# EUROPEAN PATENT APPLICATION

(11) **EP 2 455 982 A2**
(43) Date of publication of application: **23.05.2012**
(21) Application number: 11189547.0
(22) Date of filing: 17.11.2011
(51) Int. Cl.: H01L 31/052, H01L 31/0236, H01L 31/18

(54) **Thin film solar cell comprising a polymer light scattering layer and manufacturing method therefor**

(30) Priority: 17.11.2010 KR 20100114652
(71) Applicant: Samsung SDI Co., Ltd., Yongin-si, Gyeonggi-do (KR); Samsung Electronics Co., Ltd., Suwon-si, Gyeonggi-do (KR)
(72) Inventor: Bessonov, Aleksandr, Gyunggi-do (KR); Cho, Young-Tae, Gyunggi-do (KR); Jung, Seung-Jae, Gyeonggi-do (KR); Park, Eun-Ah, Gyunggi-do (KR); Hwang, Eun-Soo, Gyunggi-do (KR)
(74) Representative: Taor, Simon Edward William

(57) **Abstract**

A thin film solar cell includes a substrate (1), a light scattering layer (e.g. a polymer layer) (2) on the substrate (1), a first electrode layer (4) on the light scattering layer (2), at least one light absorption layer (5) on the first electrode layer (4) and a second electrode layer (7) on the light absorption layer (5). The light scattering layer (2) may include a micropattern, which may efficiently scatter solar radiation incident through the substrate (1). The light absorption layer (5) may comprise a plurality of light absorption layers (51,52,53).

## Description

### BACKGROUND

### 1. Field

Embodiments relate to a thin film solar cell and, more particularly, to a thin film solar cell with improved efficiency through increased light scattering coefficient and solar absorption thereof, and to a method for manufacturing the same.

### 2. Description of the Related Art

A solar cell is a device that converts light (solar energy) into electrical current (electrical energy) utilizing characteristics of semiconductors and has a PN junction structure formed by joining p-type and n-type semiconductors. When incident light enters a solar cell, holes and electrons are generated in the semiconductors. The holes move toward the p-type semiconductor while the electrons move toward the n-type semiconductor, due to an electric field created by PN joining, so as to generate a potential difference and thus power.

The solar cell may be classified into a bulk (substrate) solar cell and a thin film solar cell. The substrate solar cell is fabricated using a semiconductor material as a substrate, while the thin film solar cell is fabricated by forming a thin film semiconductor on a substrate, e.g., on a glass, or the like. Although the thin film solar cell may exhibit slightly reduced efficiency, as compared to the substrate solar cell, the thin film solar cell may be fabricated to a small thickness using a relatively low cost material. Therefore, the thin film solar cell may have reduced production costs and may be well suited for mass production.

The thin film solar cell is generally manufactured by forming a front electrode on a substrate, e.g., on glass, providing a semiconductor light absorption layer on the front electrode, and forming a rear electrode above the light absorption layer. Light may be incident on the light absorption layer and converted to electrical energy.

### SUMMARY

Some embodiments of the invention provide a thin film solar cell with a light scattering layer on a substrate to enhance light absorption by scattering long-wavelength solar radiation, as well as a method for manufacturing the same.

Example embodiments provide a thin film solar cell, including a substrate, a light scattering layer on the substrate, a first electrode layer on the light scattering layer, a plurality of light absorption layers on the first electrode layer, and a second electrode layer on the plurality of light absorption layers.

The light scattering layer may include a polymer.

The light scattering layer may include a polymer doped with transparent conductive oxide nanoparticles.

The transparent conductive oxide may be at least one of SnO₂ fluorine (F)-doped SnO₂, aluminum (Al) and boron (B)-doped ZnO, ZrO₂ In₂O₃ and TiO₂.

The polymer may include at least one of a UV-curable acrylate resin and a thermosetting acrylate resin.

The light scattering layer may include a micropattern having an irregular arrangement of structures, the structures being pyramid-shaped or trapezoidal.

The first electrode layer may include a transparent conductive oxide.

The transparent conductive oxide may be at least one of SnO₂, fluorine (F)-doped SnO₂, aluminum (Al)-doped ZnO, boron (B)-doped ZnO, and TiO₂.

The plurality of light absorption layers may be sequentially stacked on each other, the plurality of light absorption layer including a first light absorption layer including amorphous silicon and a second light absorption layer including amorphous silicon-germanium and/or microcrystalline silicon.

The plurality of light absorption layers may further include a third light absorption layer, the second light absorption layer including amorphous silicon-germanium, and the third light absorption layer including microcrystalline silicon.

The plurality of light absorption layers may further include a third light absorption layer, the second light absorption layer including microcrystalline silicon, and a third light absorption layer including amorphous silicon-germanium.

The second electrode layer may include a conductive material containing aluminum and silver.

Example embodiments may also provide a method of manufacturing a thin film solar cell, including forming a light scattering layer a substrate, forming a first electrode layer on the light scattering layer, forming a plurality of light absorption layers on the first electrode layer, and forming a second electrode layer on the plurality of light absorption layers.

The manufacturing method may further include applying a polymer to the substrate to form a polymer film, pressing a mold having a micropattern to the polymer film, hardening the polymer film while pressing the mold thereto, releasing the mold from the polymer film to form the light scattering layer, such that the micropattern is transformed from the mold to the polymer film, applying a transparent conductive oxide to the light scattering layer to form the first electrode layer, depositing a semiconductor material on the first electrode layer to form the plurality of light absorption layers, and applying a conductive material to the light absorption layers to form the second electrode layer.

Applying the polymer to the substrate may include using a polymer including at least one of a UV-curable acrylate resin and a thermosetting acrylate resin. Imprinting a UV-curable acrylate resin or a thermosetting resin on a substrate to form a light scattering layer with irregularly arranged structures, may result that solar radiation of long wavelengths of more than about 800 nm is scattered from the light scattering layer.

Applying the polymer to the substrate may further include doping the polymer with transparent conductive oxide nanoparticles.

Using the doped polymer with the transparent conductive oxide may include using a polymer with at least one of SnO₂ fluorine (F)-doped SnO₂ aluminum (Al) and boron (B)-doped ZnO, ZrO₂, In₂O₃ and TiO₂.

Pressing the mold to the polymer film may include using a micropattern having a size ranging from about 800 nm to about 1200 nm.

Hardening the polymer may include curing the polymer using heat or UV radiation.

Forming the first electrode layer may include applying the transparent conductive oxide to the light scattering layer through sputtering or LPCVD. Applying the transparent conductive oxide to the light scattering layer to form the first electrode layer with irregularly arranged structures by sputtering or LPCVD may result that solar radiation of short wavelengths ranging from about 200 nm to about 800 nm is scattered from the first electrode layer;

Applying the transparent conductive oxide may include using at least one of SnO₂, fluorine (F)-doped SnO₂, aluminum (Al)-doped ZnO, boron (B)-doped ZnO, and TiO₂.

Forming the plurality of light absorption layers may include depositing amorphous silicon on the first electrode layer to form a first light absorption layer, and depositing at least one of amorphous silicon-germanium and microcrystalline silicon on the first light absorption layer to form a second light absorption layer.

According to an aspect of the invention, there is provided a thin film solar cell as set out in claim 1. Preferred features are set out in claims 2 to 11.

According to another aspect of the invention, there is provided a method of manufacturing a thin film solar cell as set out in claim 12. Preferred features are set out in claims 13 to 17.

According to another aspect of the invention, there is provided a method for manufacturing a thin film solar cell, the method including imprinting a UV-curable acrylate resin or a thermosetting resin on a substrate to form a light scattering layer with irregularly arranged structures, such that solar radiation of long wavelengths of more than about 800 nm is scattered from the light scattering layer, applying transparent conductive oxide to the light scattering layer to form a first electrode layer with irregularly arranged structures by sputtering or LPCVD, such that solar radiation of short wavelengths ranging from about 200 nm to about 800 nm is scattered from the first electrode layer, depositing a semiconductor material on the first electrode layer to form a plurality of light absorption layers, and applying a conductive material on light absorption layers to form a second electrode layer.

### BRIEF DESCRIPTION OF THE DRAWINGS

The above and other features and advantages will become more apparent to those of ordinary skill in the art by describing in detail exemplary embodiments with reference to the attached drawings, in which:

FIGS. 1A, 1B, 1C and 1D illustrate schematic views of cross-sections of a thin film solar cell according to embodiments;

FIG. 2 illustrates a scanning electron microscope (SEM) image of a micropattern of a light scattering layer according to an embodiment;

FIG. 3 illustrates an atomic force microscope (AFM) image of a micropattern of a light scattering layer according to an embodiment;

FIG. 4 illustrates a conceptual view of a scattered condition of solar radiation from a light scattering layer according to an embodiment;

FIG. 5 illustrates a graph showing results of measuring the cross-section of the light scattering layer according to an embodiment through AFM;

FIG. 6 illustrates an SEM image of a micropattern of a first electrode layer according to an embodiment; and

FIG. 7 illustrates conceptual views of processes in a method for manufacturing a thin film solar cell according to an embodiment.

### DETAILED DESCRIPTION

Example embodiments will now be described more fully hereinafter with reference to the accompanying drawings; however, they may be embodied in different forms and should not be construed as limited to the embodiments set forth herein. Rather, these embodiments are provided so that this disclosure will be thorough and complete, and will fully convey the scope of the invention to those skilled in the art.

In the drawing figures, the dimensions of layers and regions may be exaggerated for clarity of illustration. It will also be understood that when a layer or element is referred to as being "on" another layer or substrate, it can be directly on the other layer or substrate, or intervening layers may also be present. In addition, it will also be understood that when a layer is referred to as being "between" two layers, it can be the only layer between the two layers, or one or more intervening layers may also be present. Like reference numerals refer to like elements throughout.

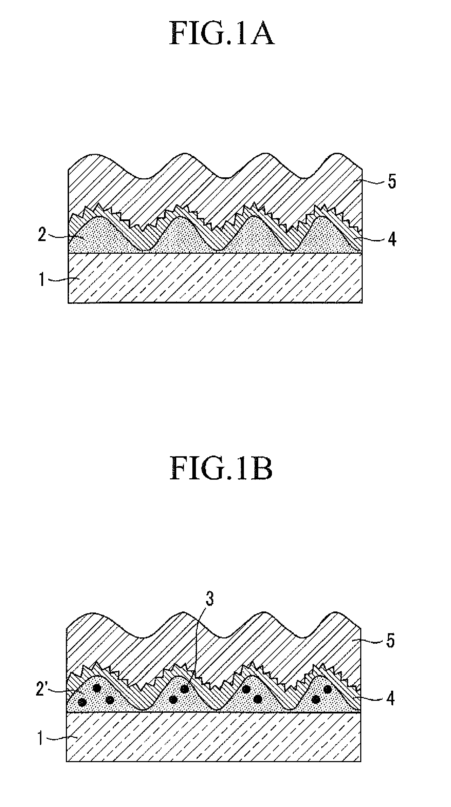

Hereinafter, an embodiment will be described in detail with reference to FIGS. 1A and 1B. FIGS. 1A and 1B are schematic views of cross-sections of a thin film solar cell according to an embodiment.

Referring to FIG. 1A, a thin film solar cell may include a substrate 1, a light scattering layer 2 provided on a front side, i.e., top surface, of the substrate 1, a first electrode layer 4 provided on a front side of the light scattering layer 2, and a light absorption layer 5 provided on a front side of the first electrode layer 4. As such, the light scattering layer 2 may be between the substrate 1 and the first electrode layer 4.

The substrate 1 may be prepared using a transparent glass substrate or a plastic substrate. For example, the substrate 1 may include one or more of polyethylene terephthalate (PET), polyethylene naphthalate (PEN), polyether sulfone (PES), polyimide (PI), or the like. The substrate 1 may be rigid or flexible.

The light scattering layer 2 may be formed on, e.g., directly on, the substrate 1. In detail, the light scattering layer 2 may be prepared using a polymer, and may be formed on a top surface of the substrate 1 through nano-imprint lithography. For example, the polymer used for the light scattering layer 2 may be a UV-curable acrylate resin or a thermosetting acrylate resin.

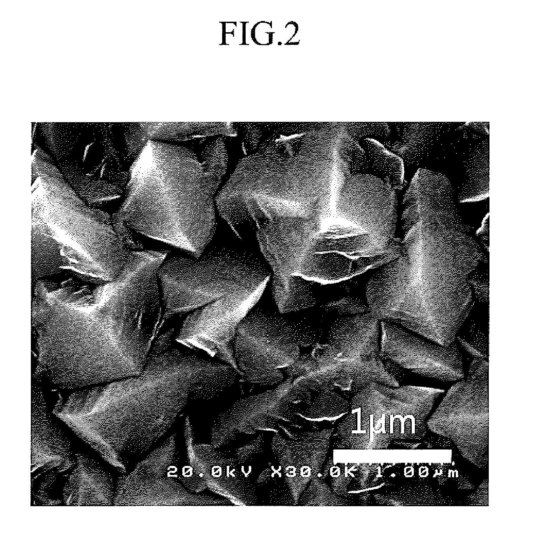

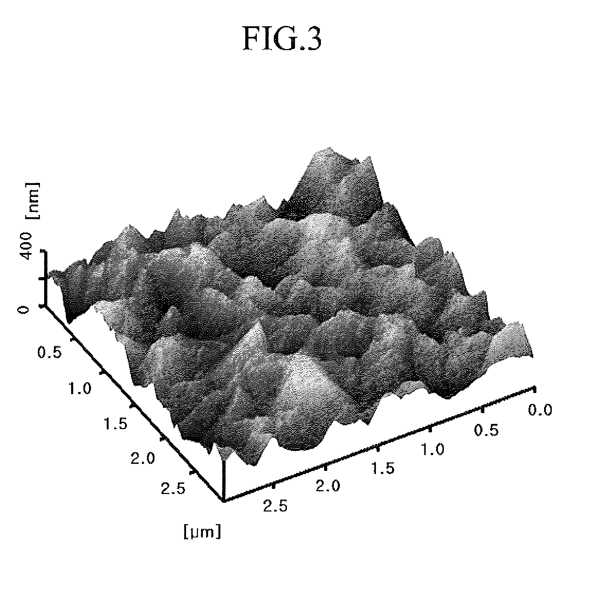

The light scattering layer 2 may include a micropattern formed therein, as will be described in more detail with reference to FIGS. 2-3. FIG. 2 is a SEM image illustrating a micropattern of the light scattering layer 2, and FIG. 3 is an AFM image illustrating a micropattern of the light scattering layer 2.

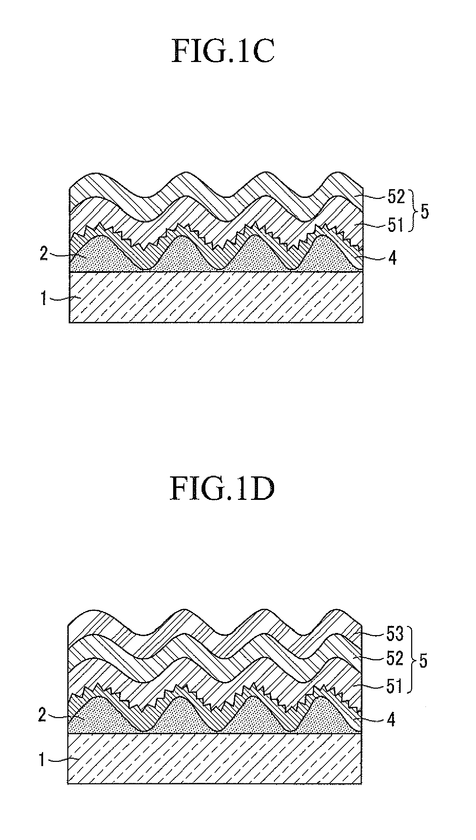

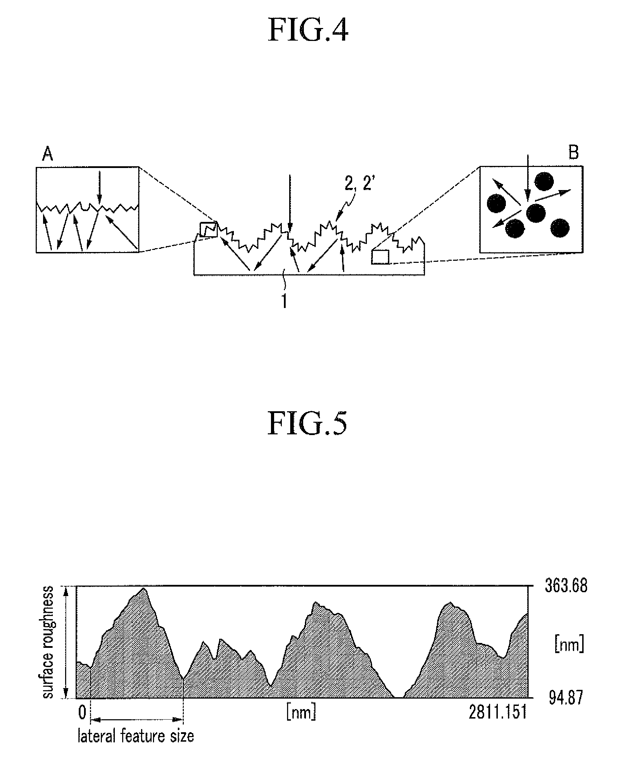

Referring to FIGS. 1 and 2-3, the light scattering layer 2 may have a micropattern formed by imprinting. The micropattern may have an irregular arrangement of structures, e.g., pyramid-shaped embossments or trapezoidal embossments. That is, marks, e.g., polygonal-shaped marks, may be pressed into a top surface 2a, i.e., a surface facing away from the substrate 1, of the light scattering layer 2 in an irregular arrangement, such that the top surface 2a of the light scattering layer 2 may include an arrangement of depressions and protrusions to define a rough, i.e., uneven, surface. The structures of the micropattern may have irregular shapes and/or an irregular arrangement on the top surface 2a of the light scattering film 2. The micropattern of the light scattering layer 2 may efficiently scatter solar radiation incident through the substrate 1, as illustrated in FIG. 4 (enlarged part A). In particular, the micropattern of the light scattering layer 2 may efficiently scatter long-wavelength solar radiation, i,e., light having a wavelength of about 800 nm or higher.

The micropattern of the light scattering layer 2 may have a lateral feature size ranging from about 800 nm to about 1200 nm and a surface roughness ranging from about 100 nm to about 300 nm (see FIG. 5). It is noted that the nano-imprint lithography (NIL) process is performed by applying a thermosetting resin or a UV-curable resin to a substrate, and hardening the same while pressing a mold, on which nano-sized micropattern is present, to the coated resin on the substrate. As such, the micropattern of the mold is transferred onto the resin coated on the substrate. The imprint resin may be applied to the substrate through spin-coating, slit-coating, dispensing, or the like.

In another example, as illustrated in FIG. 1B, a light scattering layer 2' may be formed of a polymer doped with transparent conductive oxide (TCO) nanoparticles 3. For example, the nanoparticles 3 may have a size of about 20 nm to about 500 nm. Examples of TCO may include SnO₂, fluorine (F)-doped SnO₂, aluminum (A1) and boron (B)-doped ZnO, ZrO₂, In₂O₃, TiO₂, or mixtures thereof. The light scattering layer 2' formed of a polymer, e.g., a UV-curable acrylate resin or a thermosetting acrylate resin, doped with the TCO nanoparticles 3 may efficiently scatter the solar radiation by the TCO nanoparticles 3 contained in the polymer, as illustrated in FIG. 4 (enlarged part B). If the light scattering film 2' includes both the micropattern and the TCO nanoparticles 3, scattering efficiency may be increased further.

In order to reduce optical loss caused by reflection of solar radiation, the polymer used for the light scattering layer 2 may have a refractive index ranging from about 1.5 to about 1.7 in relation to the solar radiation with a wavelength of about 587 nm. Further, the doped polymer used for the light scattering layer 2' may have a refractive index ranging from about 1.5 to about 1.9 in relation to the solar radiation with a wavelength of about 587 nm, and the TCO nanoparticles 3 may have a refractive index of about 1.5 to about 2.5 in relation to the solar radiation with a wavelength of about 587 nm.

The first electrode layer 4 may be formed on the light scattering layer 2 using TCO. Examples of the TCO may include SnO₂, fluorine (F)-doped SnO₂, aluminum (Al)-doped ZnO, boron (B)-doped ZnO, TiO₂, or mixtures thereof.

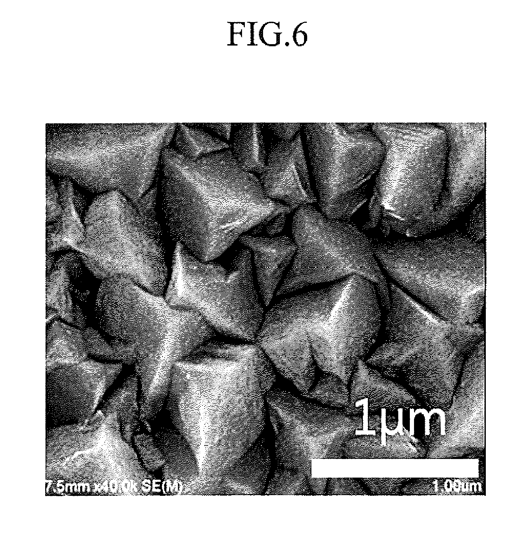

For example, the first electrode layer 4 may be provided on the light scattering layer 2 (or light scattering layer 2') through sputtering or LPCVD. Similarly to the light scattering layer 2, the first electrode layer 4 may have a micropattern including an irregular arrangement of structures, e.g., pyramid-shaped embossments or trapezoidal embossments (FIG. 6).

In order to reduce optical loss caused by reflection of solar radiation, the first electrode layer 4 may have a refractive index ranging from about 1.8 to about 2.5 in relation to solar radiation with a wavelength of about 587 nm. A lateral feature size of the micropattern in the first electrode layer 4 may range from about 50 nm to about 800 nm, while a surface roughness of the same may range from about 10 nm to about 100 nm (FIG. 6). As such, the first electrode layer 4 may efficiently scatter short-wavelength solar radiation, e.g., wavelengths at about 200 to about 800 nm.

As described above, a thin film solar cell according to example embodiments may include a double-textured structure for the light scattering layer 2 and the first electrode layer 4. That is, each of the light scattering layer 2 and the first electrode layer 4 may have a micropattern of irregularly arranged structures. The micropattern of the light scattering layer 2 may be different from the micropattern of the first electrode layer 4 in terms of surface roughness and lateral feature size in order to adjust scattering of different wavelengths, i.e., long vs. short wavelengths. As the micropattern of the light scattering layer 2 and the first electrode layer 4 are adjusted to have different surface features in accordance with different wavelengths, the thin film solar cell may efficiently scatter long-wavelength solar radiation, i.e., at about 800 nm or higher, via the light scattering layer 2 and short-wavelength solar radiation, e.g., at about 200 nm to about 800 nm, via the first electrode layer 4.

An optical path of solar radiation in the thin film solar cell according to example embodiments may be increased and solar absorption onto the light absorption layer 5 may also be increased. As such the solar cell efficiency may be improved further.

The light absorption layer 5 may be formed using a semiconductor material, e.g., silicon, and may be provided on a front side of the first electrode layer 4. More particularly, the light absorption layer 5 may have a PIN structure including a positive (P-type) semiconductor layer, an intrinsic (I-type) semiconductor layer, and a negative (N-type) semiconductor layer. The light absorption layer 5 may be a single layer or a multi-layer structure.

For instance, solar radiation incident upon the light absorption layer 5 through a substrate 1 penetrates a p-type amorphous silicon layer, is absorbed into an I-type amorphous silicon layer, and generates electrons and holes in the I-type amorphous silicon layer by solar radiation that has greater energy than an optical band gap of amorphous silicon within the I-type amorphous silicon layer. Such electrons and holes generated in the I-type amorphous silicon layer are collected in an N-type amorphous silicon layer as well as the P-type amorphous silicon layer, respectively, by an internal electric field, and then, are supplied to an external circuit, via electrodes such as the first electrode layer 4 and a second electrode layer.

As shown in FIG. 1C, the light absorption layer 5 may have a multi-layer structure, i.e., the light absorption layer 5 may include a plurality of light absorption layers stacked on top of each other. For example, the light absorption layer 5 may include a first light absorption layer 51 and a second light absorption layer 52 provided on a front side of the first absorption layer 51. The first light absorption layer 51 may have a PIN structure including amorphous silicon (a-Si), while the second light absorption layer 52 may have a PIN structure including amorphous silicon-germanium (a-Si:Ge) or microcrystalline silicon (µc-Si).

In another example, as shown in FIG. 1D, the light absorption layer 5 may include a first light absorption layer 51, a second light absorption layer 52 provided on a front side of the first light absorption layer 51, and a third light absorption layer 53provided on a front side of the second light absorption layer 52. The first light absorption layer 51 may have a PIN structure including amorphous silicon (a-Si), the second light absorption layer 52 may have a PIN structure including amorphous silicon-germanium (a-Si:Ge), and the third light absorption layer 53 may have a PIN structure including microcrystalline silicon (µc-Si). In yet another example, the second light absorption layer 52 may have a PIN structure including microcrystalline silicon (µc-Si), and the third light absorption layer 53 may have a PIN structure including amorphous silicon-germanium (a-Si:Ge).

For a light absorption layer 5 having a tandem structure, e.g., a multi-layered structure, the first light absorption layer 51 may absorb short-wavelength solar radiation, e.g., at about 200 nm to about 800 nm, while the second and/or third light absorption layers 52, 53 may absorb long-wavelength solar radiation, e.g., at more than 800 nm.

Accordingly, the long-wavelength solar radiation, i.e., light having a wavelength of more than 800 nm, is scattered through the light scattering layer 2 and is absorbed in the second or third light absorption layer. The short-wavelength solar radiation, i.e., light having a wavelength ranging from about 200 nm to about 800 nm, is scattered through the first electrode layer 4 and is absorbed in the first light absorption layer 51. Therefore, both the long-wavelength solar radiation and the short-wavelength solar radiation are uniformly absorbed, thereby improving solar cell efficiency.

The second electrode layer 7 may be provided on a front side of the light absorption layer 5, and may be prepared using a conductive material containing aluminum (Al) and/or silver (Ag) which have excellent solar reflectance.

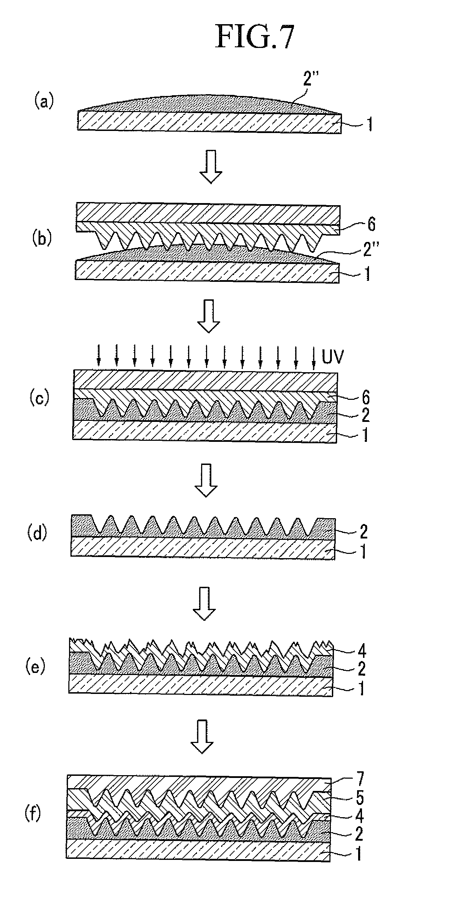

FIG. 7 is a schematic view illustrating processes of a manufacturing method of a thin film solar cell according to an embodiment. The stages in the manufacturing process are designed by (a) through (f) in FIG. 7.

Referring to FIG. 7, a polymer 2" used for imprinting ('imprinting polymer') is applied to the substrate 1 (part (a) of FIG. 7). The polymer 2" may be UV-curable acrylate resin or a thermosetting acrylate resin. For example, the polymer 2" may be doped with TCO nanoparticles 3, e.g., particles of SnO₂, fluorine (F)-doped SnO₂, aluminum (Al) and boron (B)-doped ZnO, ZrO₂, In₂O₃, TiO₂ or mixtures thereof. The polymer 2" may be applied to the substrate 1 through spin-coating, slit-coating and/or dispensing.

After applying the polymer 2" to the substrate 1, a mold 6 may be pressed to the polymer 2" (part (b) of FIG. 7). The mold 6 may include a micropattern structure imprinted thereon, i.e., a micropattern having irregularly arranged positive and negative parts. Such a micropattern may have an irregular arrangement of pyramid-shaped or trapezoidal embosses. While facing the micropattern to the overall top side of the imprinting polymer applied to the substrate 1, the mold 6 is pressed to the polymer 2". The pressing of the mold may be conducted using a roller under a pressure of about 0.8 MPa while operating the roller at a speed of about 0.05 m/s. In order to replicate precise micropattern onto the polymer, a surface of the mold may be subjected to anti-adhesive coating before the imprinting process.

After pressing the mold 6 to the polymer, heating or UV irradiation may be conducted to harden the polymer 2" into the light scattering layer 2 (part (c) of FIG. 7). In the case of UV irradiation, the mold 6 may be made of UV permeable materials. The UV radiation curing may be executed for about 30 seconds to about 90 seconds using a UV lamp that has a wavelength of about 365 nm and an intensity of about 2.3 mW/cm² as a light source.

After hardening the polymer 2", the mold 6 is released from the polymer of the substrate 1. When the mold is released from the polymer, negative parts, i.e., corresponding to positive parts of the mold 6, may be formed on a surface of the hardened polymer, i.e., the resultant light scattering layer 2. Likewise, positive parts, i.e., corresponding to negative parts of the mold, may also be formed on the same surface of the polymer. As a result, the micropattern having the irregular arrangement of pyramid-shaped or trapezoidal embosses, which is provided on the mold 6, may be transferred to the resultant light scattering layer (see FIG. 2 and FIG. 7(d)). The micropattern may have a lateral feature size ranging from about 800 nm to about 1200 nm and a surface roughness ranging from about 100 nm to about 300 nm. After releasing the mold 6 from the hardened polymer, i.e., the resultant light scattering layer 2 with the micropattern transferred thereto, may be further subjected to washing using isopropyl alcohol and baking at about 200 °C for about 2 hours.

After the micropattern is formed on the polymer of the light scattering layer 2, TCO may be applied to a front side of the light scattering layer 2. Examples of the TCO may include SnO₂, fluorine (F)-doped SnO₂, aluminum (Al)-doped ZnO, boron (B)-doped ZnO, TiO₂ or mixtures thereof. The TCO may be deposited on the front side of the light scattering layer 2 through sputtering or LPCVD, in order to form the first electrode layer 4 (part (e) of FIG. 7). A double-texture type structure, as described above, may scatter both the long-wavelength solar radiation and the short-wavelength solar radiation, thereby increasing an optical path length (OPL) and enhancing the efficiency of a solar cell.

After the formation of the first electrode layer 4, the light absorption layer 5 may be provided on top of the first electrode layer 4 (part (f) of FIG. 7). The light absorption layer 5 may be formed using any semiconductor material such as amorphous silicon, amorphous silicon-germanium, microcrystalline silicon, or the like, and have a multiple and/or tandem structure. A first light absorption layer 51 and a second light absorption layer 52, as described above, may be sequentially laminated on the first electrode layer 4. In case of a triple-structure, a third light absorption layer 53 may be further provided on the second light absorption layer 52. These light absorption layers may be sequentially formed above the first electrode layer 4 by any conventional deposition method such as CVD. After the formation of the light absorption layer 5, a second electrode layer 7 made of a conductive material having a high light reflectance such as aluminum, silver, or the like, may be provided on a front side of the light absorption layer 5.

According to example embodiments, a light scattering coefficient of the long-wavelength solar radiation is improved to preferably increase an optical path length (OPL), thus enhancing efficiency of the solar cell. In addition, by decreasing optical loss due to reflection of the solar radiation, the efficiency of the solar cell may be further improved. In contrast, while a conventional thin film solar cell may transmit short-wavelength solar radiation through a light absorption layer formed of a transparent conductive film on a front electrode, the conventional thin film solar cell may exhibit a low scattering coefficient with respect to long-wavelength solar radiation. As such, the conventional thin film solar cell may have poor absorption of long-wavelength solar radiation.

Example embodiments have been disclosed herein, and although specific terms are employed, they are used and are to be interpreted in a generic and descriptive sense only and not for purpose of limitation. In some instances, as would be apparent to one of ordinary skill in the art as of the filing of the present application, features, characteristics, and/or elements described in connection with a particular embodiment may be used singly or in combination with features, characteristics, and/or elements described in connection with other embodiments unless otherwise specifically indicated. Accordingly, it will be understood by those of skill in the art that various changes in form and details may be made without departing from the scope of the example embodiments as set forth in the following claims.

## Claims

1. A thin film solar cell, comprising:
a substrate;
a light scattering layer on the substrate;
a first electrode layer on the light scattering layer;
at least one light absorption layer on the first electrode layer; and
a second electrode layer on the plurality of light absorption layers.

2. A thin film solar cell according to claim 1, wherein the thin film solar cell comprises a plurality of light absorption layers on the first electrode layer.

3. A thin film solar cell according to claim 1 or 2, wherein the light scattering layer includes a polymer.

4. A thin film solar cell according to claim 3, wherein the light scattering layer includes a polymer doped with transparent conductive oxide nanoparticles;
optionally wherein the transparent conductive oxide is at least one of SnO₂, fluorine (F)-doped SnO₂, aluminum (Al) and boron (B)-doped ZnO, ZrO₂, In₂O₃, and TiO₂.

5. A thin film solar cell according to claim 3 or 4, wherein the polymer includes at least one of a UV-curable acrylate resin and a thermosetting acrylate resin.

6. A thin film solar cell according to any one of claims 1 to 5, wherein the light scattering layer includes a micropattern having an irregular arrangement of structures, the structures being pyramid-shaped or trapezoidal.

7. A thin film solar cell according to any one of claims 1 to 6, wherein the first electrode layer includes a transparent conductive oxide;
optionally wherein the transparent conductive oxide is at least one of SnO₂, fluorine (F)-doped SnO₂, aluminum (Al)-doped ZnO, boron (B)-doped ZnO, and TiO₂.

8. A thin film solar cell according to any one of claims 1 to 7 when dependent on claim 2, wherein the plurality of light absorption layers are sequentially stacked on each other, the plurality of light absorption layer including a first light absorption layer including amorphous silicon and a second light absorption layer including amorphous silicon-germanium and/or microcrystalline silicon.

9. A thin film solar cell according to claim 8, wherein the plurality of light absorption layers further comprises a third light absorption layer, the second light absorption layers including amorphous silicon-germanium, and the third light absorption layer including microcrystalline silicon.

10. A thin film solar cell according to claim 8, wherein the plurality of light absorption layers further comprises a third light absorption layer, the second light absorption layer including microcrystalline silicon, and the third light absorption layer including amorphous silicon-germanium,

11. A thin film solar cell according to any one of claims 1 to 10, wherein the second electrode layer includes a conductive material containing aluminum and silver.

12. A method of manufacturing a thin film solar cell, the comprising:
forming a light scattering layer on a substrate;
forming a first electrode layer on the light scattering layer;
forming at least one light absorption layer on the first electrode layer; and
forming a second electrode layer on the plurality of light absorption layers.

13. A manufacturing method according to claim 12, further comprising:
applying a polymer to the substrate to form a polymer film;
pressing a mold having a micropattern to the polymer film;
hardening the polymer film while pressing the mold thereto;
releasing the mold from the polymer film to form the light scattering layer, such that the micropattern is transformed from the mold to the polymer film;
applying a transparent conductive oxide to the light scattering layer to form the first electrode layer;
depositing a semiconductor material on the first electrode layer to form the at least one light absorption layer; and
applying a conductive material to the light absorption layers to form the second electrode layer.

14. The manufacturing method as claimed in claim 13, wherein applying the polymer to the substrate includes using a polymer including at least one of a UV-curable acrylate resin and a thermosetting acrylate resin;
optionally wherein applying the polymer to the substrate further comprises doping the polymer film with transparent conductive oxide nanoparticles, further optionally wherein using the doped polymer film with the transparent conductive oxide includes using a polymer with at least one of SnO₂, fluorine (F)-doped SnO₂, aluminum (Al) and boron (B)-doped ZnO, ZrO₂, In₂O₃, and TiO₂, further optionally wherein pressing the mold to the polymer film includes using a micropattern having a size ranging from about 800 nm to about 1200 nm.

15. A manufacturing method as claimed in claim 13 or 14, wherein hardening the polymer includes curing the polymer using heat or UV radiation.

16. A manufacturing method according to any one of claims 12 to 15, wherein forming the first electrode layer includes applying a transparent conductive oxide to the light scattering layer through sputtering or LPCVD;
optionally wherein applying the transparent conductive oxide includes using at least one of SnO₂, fluorine (F)-doped SnO₂, aluminum (Al)-doped ZnO, boron (B)-doped ZnO, and TiO₂.

17. A manufacturing method according to any one of claims 12 to 16, comprising forming a plurality of light absorption layers, including depositing amorphous silicon on the first electrode layer to form a first light absorption layer, and depositing at least one of amorphous silicon-germanium and microcrystalline silicon on the first light absorption layer to form a second light absorption layer.
